# EUROPÄISCHE PATENTSCHRIFT

(11) **EP 1 110 253 B1**
(45) Veröffentlichungstag und Bekanntmachung des Hinweises auf die Patenterteilung: **04.04.2007**
(21) Anmeldenummer: 00943648.6
(22) Anmeldetag: 30.05.2000
(51) Int. Cl.: H01L 41/083, H01L 41/047

(54) **PIEZOAKTOR MIT VERBESSERTER WÄRMEABLEITUNG**
PIEZOELECTRIC ACTUATOR WITH IMPROVED HEAT DISSIPATION
ACTEUR PIEZO-ELECTRIQUE A DISSIPATION AMELIOREE DE LA CHALEUR

(30) Priorität: 19.06.1999 DE 19928176
(43) Veröffentlichungstag der Anmeldung: 27.06.2001
(73) Patentinhaber: ROBERT BOSCH GMBH, 70442 Stuttgart (DE)
(72) Erfinder: HEINZ, Rudolf, D-71272 Renningen (DE); SUGG, Bertram, D-70839 Gerlingen (DE); BOECKING, Friedrich, D-70499 Stuttgart (DE)
(86) Internationale Anmeldenummer: PCT/DE2000/001747
(87) Internationale Veröffentlichungsnummer: WO 2000/079613

(56) Entgegenhaltungen:
- PATENT ABSTRACTS OF JAPAN vol. 1995, no. 07, 31. August 1995 (1995-08-31) & JP 07 099347 A (NIPPONDENSO CO LTD), 11. April 1995 (1995-04-11) -& JP 07 099347 A (NIPPONDENSO CO LTD) 11. April 1995 (1995-04-11)

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen der Hauptansprüche 1 und 2. Ein derartiger Aktor ist aus der JP-07-099 347 A bekannt.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Bei der Positionierung von Ventilen werden die zuvor genannten Piezoaktoren häufig eingesetzt. Dabei ist hier unter anderem zu beachten, dass ihr Hubvermögen zur Betätigung, beispielsweise eines Ventilstössels, relativ klein ist und dabei die Wärmedehnung der Keramik des Piezoelements zu einer Drift der Position des Ventilstössels ohne eine Ansteuerung des Piezoelements führen kann und außerdem die Kontaktierung an aktiven Teilen des Piezoaktors schwierig ist.

### Vorteile der Erfindung

Der eingangs beschriebene Piezoaktor, der beispielsweise zur Betätigung eines mechanischen Bauteils verwendbar sein kann, weist in vorteilhafter Weise ein Piezoelement zur Beaufschlagung eines Betätigungselements mit einer Zug- oder Druckkraft auf, das mit einem Mehrschichtaufbau von Piezolagen mit dazwischen angeordneten Elektroden und mit einer wechselseitigen seitlichen Kontaktierung der Elektroden über Außenelektroden versehen ist.

Es ist hierbei besonders vorteilhaft, dass die äußeren elektrischen Anschlüsse für die seitliche Kontaktierung an einem inaktiven Endbereich im Lagenaufbau angebracht sind und der Endbereich einen Kern mit guter Wärmeleitfähigkeit aufweist. Hierdurch kann auf einfache Weise die sicher herzustellende äußere Kontaktierung des Piezoaktors an inaktiven Endbereichen, die nicht mit Zug- oder Druckkräften beaufschlagt werden, mit einer guten Wärmeableitung verbunden werden um die eingangs geschilderten Nachteile zu vermeiden.

Bei einer vorteilhaften Ausführungsform weist der inaktive Endbereich eine relativ dünne, elektrisch isolierende Deckschicht auf dem Lagenaufbau auf. Die Deckschicht ist mit einem wärmeleitenden Kern versehen, an dem wiederum seitlich elektrisch isolierende Keramikschichten angebracht sind. An den Keramikschichten ist dabei die Verbindung zwischen den Außenelektroden und den äußeren elektrischen Anschlüssen herstellbar. Vorzugsweise kann dies mit einer Lotschicht erfolgen, die auf die jeweilige Keramikschicht im Bereich der Außenelektroden aufgetragen wird.

Bei einer anderen, ebenfalls sehr vorteilhaften Ausführungsform, ist der inaktive Endbereich aus einem elektrisch isolierenden Keramikteil gebildet, an dem seitlich die Verbindung zwischen den Außenelektroden und den äußeren elektrischen Anschlüssen herstellbar ist. In die Keramikschicht ist bei dieser Ausführungsform ein wärmeleitender Kern eingelassen. Besonders bevorzugt weist der Kern in der Ebene der Lagen eine runde, somit insgesamt scheibenförmige Kontur auf.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung-und auf anderen Gebieten verwirklicht sein und vorteilhafte sowie für sich schutzfähige Ausführungen darstellen können, für die hier Schutz beansprucht wird.

### Zeichnung

Ausführungsbeispiele des erfindungsgemäßen Piezoaktors, beispielsweise zur Positionierung eines Ventils, werden anhand der Zeichnung erläutert. Es zeigen:
Figur 1 einen Schnitt durch einen Piezoaktor mit einem kontaktierbaren inaktiven Endbereich, der aus einer dünnen Deckschicht und einem darauf angeordneten wärmeleitenden Kern besteht;
Figur 2 eine Ansicht des Endbereichs an der Schnittlinie A-A nach der Figur 1;
Figur 3 einen Schnitt durch einen Piezoaktor nach einem zweiten Ausführungsbeispiel mit einem kontaktierbaren inaktiven Endbereich aus Keramik, in den ein scheibenförmiger wärmeleitender Kern eingelassen ist und
Figur 4 eine Ansicht des Endbereichs an der Schnittlinie A-A nach der Figur 3.

### Beschreibung der Ausführungsbeispiele

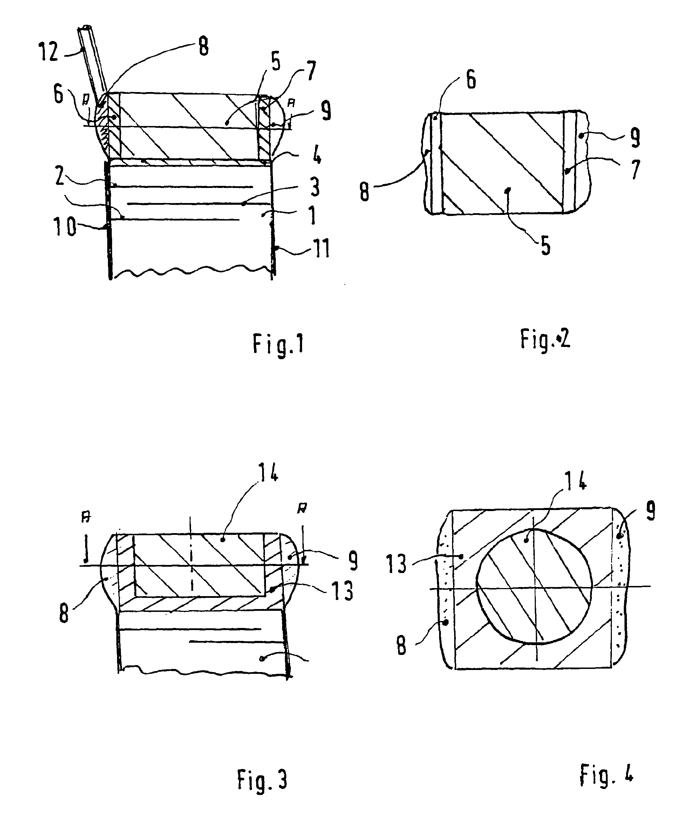

In Figur 1 ist ein Piezoaktor 1 gezeigt, der in an sich bekannter Weise aus Piezofolien eines Keramikmaterials mit einer geeigneten Kristallstruktur aufgebaut ist, so dass unter Ausnutzung des sogenannten Piezoeffekts bei Anlage einer äußeren elektrischen Spannung an Innenelektroden 2 und 3 eine mechanische Reaktion des Piezoaktors 1 erfolgt. Am Ende des Lagenaufbaus des Piezoaktors 1 ist beim Ausführungsbeispiel nach der Figur 1 eine dünne inaktive Deckschicht 4 angebracht, die zu einem inaktiven Endbereich gehört und eine elektrische Isolation des Endbereichs zum Lagenaufbau bewirkt. Auf der Deckschicht 4 ist ein gut wärmeleitender Kern 5 angeordnet, über den die Wärme vom Piezoaktor 1 nach außen abgeführt werden kann.

An Seitenflächen des Kerns 5 sind ebenfalls inaktive, elektrisch isolierende Keramikdeckschichten 6 und 7 angebracht, die mit einer Lotschicht 8 bzw. 9 versehen werden können. Diese Anordnung ist auch insbesondere aus dem Schnitt entlang der Linie A-A in Figur 2 zu entnehmen.

Mit denInnenelektroden 2 und 3 stehen flächige Außenelektroden 10 und 11 in Kontakt, die jeweils mit den Lotschichten 8 bzw. 9 verbunden werden. An den Lotschichten 8 und 9 können dann wiederum äußere Anschlüsse (gezeigt ist hier ein Anschlussdraht 12) angebracht werden, über die der Piezoaktor 1 mit einer elektrischen Spannung versorgt werden kann.

Bei einem zweiten Ausführungsbeispiel aus Figur 3 ist am Ende des Lagenaufbaus des Piezoaktors 1 ein einstückiges Keramikteil 13 angebracht, das zu dem inaktiven Endbereich gehört und die elektrische Isolation des Endbereichs zum Lagenaufbau bewirkt. In das einstückige Keramikteil 13 ist ein gut wärmeleitender, scheibenförmiger Kern 14 eingelassen, über den die Wärme vom Piezoaktor 1 wie beim Ausführungsbeispiel nach den Figuren 1 und 2 nach außen abgeführt werden kann.

An Seitenflächen des Kerns 14 sind hier die Lotschichten 8 und 9 in vergleichbarer Weise wie beim Ausführungsbeispiel nach den Figuren 1 und 2 angebracht. Diese Anordnung ist auch hier insbesondere aus dem Schnitt entlang der Linie A-A in Figur 4 zu entnehmen, wobei die runde Kontur des Kerns 14 erkennbar ist.

## Patentansprüche

1. Piezoaktor, mit einem Piezoelement zur Beaufschlagung eines Betätigungselements mit einer Zug- oder Druckkraft, mit einem Mehrschichtaufbau von Piezolagen mit dazwischen angeordneten Innenelektroden (2, 3) und mit einer wechselseitigen seitlichen Kontaktierung der Elektroden (2, 3) über Außenelektroden (10, 11), wobei der Mehrschichtaufbau von Piezolagen einen inaktiven Endbereich (4, 5, 6, 7) umfasst, an dem äußere elektrische Anschlüsse (12) für die seitliche Kontaktierung angebracht sind und der einen Kern (5) mit guter Wärmeleitfähigkeit aufweist,
**dadurch gekennzeichnet,**
**dass** der inaktive Endbereich (4, 5, 6, 7) aus einer elektrisch isolierenden Deckschicht (4) auf dem Lagenaufbau, dem Kern (5) und aus seitlich am Kern (5) angebrachten elektrisch isolierenden Keramikschichten (6, 7) besteht, wobei an diesen Keramikschichten (6, 7) die Verbindung zwischen den Außenelektroden (10, 11) und den äußeren elektrischen Anschlüssen (12) herstellbar ist.

2. Piezoaktor, mit einem Piezoelement zur Beaufschlagung eines Betätigungselements mit einer Zug- oder Druckkraft, mit einem Mehrschichtaufbau von Piezolagen mit dazwischen angeordneten Innenelektroden (2, 3) und mit einer wechselseitigen seitlichen Kontaktierung der Elektroden (2, 3) über Außenelektroden (10, 11), wobei der Mehrschichtaufbau von Piezolagen einen inaktiven Endbereich (13, 14) umfasst, an dem äußere elektrische Anschlüsse (12) für die seitliche Kontaktierung angebracht sind und der einen Kern (14) mit guter Wärmeleitfähigkeit aufweist,
**dadurch gekennzeichnet,**
**dass** der inaktive Endbereich (13, 14) aus einem elektrisch isolierenden Keramikteil (13) besteht, an dem seitlich die Verbindung zwischen den Außenelektroden (10, 11) und den äußeren elektrischen Anschlüssen (12) herstellbar ist und der Kern (14) in das Keramikteil (13) eingelassen ist.

3. Piezoaktor nach Anspruch 2, **dadurch gekennzeichnet, dass**
- der Kern (14) in der Ebene der Lagen eine runde Kontur aufweist.

4. Piezoaktor nach einem der vorhergehenden Ansprüche,
**dadurch gekennzeichnet, dass**
- die Verbindung zwischen den Außenelektroden (10,11) und den elektrischen Anschlüssen (12) mit einer Lotschicht (8,9) auf der Keramikschicht (6,7;13) herstellbar ist.

## Claims

1. Piezoelectric actuator, with a piezoelectric element for acting on an actuating element with a tensile or compressive force, with a multilayer structure of piezoelectric layers with internal electrodes (2, 3) arranged in between and with alternate lateral contacting of the electrodes (2, 3) via external electrodes (10, 11), the multilayer structure of piezoelectric layers comprising an inactive end region (4, 5, 6, 7), to which outer electrical terminals (12) for the lateral contacting are attached and which has a core (5) with good thermal conductivity, **characterized in that** the inactive end region (4, 5, 6, 7) comprises an electrically insulating outer layer (4) on the layer structure, the core (5) and electrically insulating ceramic layers (6, 7) laterally attached to the core (5), it being possible for the connection between the external electrodes (10, 11) and the outer electrical terminals (12) to be established at these ceramic layers (6, 7).

2. Piezoelectric actuator, with a piezoelectric element for acting on an actuating element with a tensile or compressive force, with a multilayer structure of piezoelectric layers with internal electrodes (2, 3) arranged in between and with alternate lateral contacting of the electrodes (2, 3) via external electrodes (10, 11), the multilayer structure of piezoelectric layers comprising an inactive end region (13, 14), to which outer electrical terminals (12) for the lateral contacting are attached and which has a core (14) with good thermal conductivity, **characterized in that** the inactive end region (13, 14) comprises an electrically insulating ceramic part (13), laterally of which the connection between the external electrodes (10, 11) and the outer electrical terminals (12) can be established and the core (14) is recessed into the ceramic part (13).

3. Piezoelectric actuator according to Claim 2, **characterized in that** the core (14) has a round contour in the plane of the layers.

4. Piezoelectric actuator according to one of the preceding claims, **characterized in that** the connection between the external electrodes (10, 11) and the electrical terminals (12) can be established by a solder layer (8, 9) on the ceramic layer (6, 7; 13).

## Revendications

1. Actionneur piézoélectrique comprenant un élément piézoélectrique pour appliquer une force de traction ou de pression sur un élément d'actionnement, avec une structure multicouche de couches piézoélectriques, des électrodes intérieures (2, 3) insérées entre celles-ci, et une mise en contact latérale mutuelle des électrodes (2, 3) par des électrodes extérieures (10, 11), la structure multicouche des couches piézoélectriques comprenant une zone terminale inactive (4, 5, 6, 7) sur laquelle sont placés des raccords électriques extérieurs (12) pour la mise en contact latérale et qui présente un noyau (5) d'une bonne conductivité thermique,
**caractérisé en ce que**
la zone terminale inactive (4, 5, 6, 7) est composée d'une couche de protection (4) électriquement isolante sur la structure de couches, du noyau (5) et de couches céramiques (6, 7) électriquement isolantes et disposées latéralement sur le noyau (5), et la liaison entre les électrodes extérieures (10, 11) et les raccords électriques extérieurs (12) est réalisée sur ces couches céramiques (6, 7).

2. Actionneur piézoélectrique comprenant un élément piézoélectrique pour appliquer une force de traction ou de pression sur un élément d'actionnement, avec une structure multicouche de couches piézoélectriques, des électrodes intérieures (2, 3) insérées entre celles-ci, et une mise en contact latérale mutuelle des électrodes (2, 3) par des électrodes extérieures (10, 11), la structure multicouche des couches piézoélectriques comprenant une zone terminale inactive (13, 14) sur laquelle sont placés des raccords électriques extérieurs (12) pour la mise en contact latérale et qui présente un noyau (14) d'une bonne conductivité thermique,
**caractérisé en ce que**
la zone terminale inactive (13, 14) est un élément céramique (13) électriquement isolant sur lequel on peut réaliser latéralement la liaison entre les électrodes extérieures (10, 11) et les raccords (12) électriques extérieurs, et le noyau (14) est inséré dans l'élément céramique (13).

3. Actionneur piézoélectrique selon la revendication 2,
**caractérisé en ce que**
le noyau (14) présente un contour rond dans le plan des couches.

4. Actionneur piézoélectrique selon l'une quelconque des revendications précédentes,
**caractérisé en ce que**
la liaison entre les électrodes extérieures (10, 11) et les raccords électriques (12) est réalisée à l'aide d'une couche de métal d'apport (8, 9) sur la couche céramique (6, 7 ; 13).
